Europäisches Patentamt

European Patent Office

Office européen des brevets

(11) Publication number: **0 115 899**

**B1**

(12) **EUROPEAN PATENT SPECIFICATION**

(45) Date of publication of patent specification: **07.09.88**

(21) Application number: **84300004.3**

(22) Date of filing: **03.01.84**

(51) Int. Cl.⁴: **G 03 F 3/10, G 03 F 7/08**

(54) Positive, laminable proofing construction.

(30) Priority: **03.01.83 US 455315**

(43) Date of publication of application:
**15.08.84 Bulletin 84/33**

(45) Publication of the grant of the patent:
**07.09.88 Bulletin 88/36**

(84) Designated Contracting States:
**BE CH DE FR GB IT LI SE**

(56) References cited:
**WO-A-81/00772
DE-A-1 912 864
US-A-4 304 836**

(73) Proprietor: **MINNESOTA MINING AND
MANUFACTURING COMPANY
3M Center, P.O. Box 33427
St. Paul, Minnesota 55133-3427 (US)**

(72) Inventor: **Koelsch, Peter M. c/o Minnesota
Mining and
Manufacturing Co. 2501 Hudson Road P.O. Box
33427
St. Paul Minnesota 55133 (US)**
Inventor: **Krech, Roger I. c/o Minnesota Mining
and
Manufacturing Co. 2501 Hudson Road P.O. Box
33427
St. Paul Minnesota 55133 (US)**

(74) Representative: **Baillie, Iain Cameron et al
c/o Ladas & Parry Isartorplatz 5
D-8000 München 2 (DE)**

Courier Press, Leamington Spa, England.

# 0 115 899

## Description

The present invention relates to positive-acting printing proofs and, in particular, to laminable positive proofs for providing color separations of original, multi-colored renditions of graphic art.

### Description of the prior art

In the photomechanical process of reproducing the tone values and color shades represented by a piece of original graphic art, it is necessary to prepare a series of color separations by photographic means so that the particular colors to be printed are first recorded on a set of separation negatives or positives by means of appropriate filtering and masking techniques.

By following known procedures, four photographic black and white separation negatives or positives are made representing the three process colors, magenta, cyan and yellow, as well as the fourth representing the black contribution. These separations are then used to make four printing plates. These plates are then mounted on an offset printing press to recreate a rendition of the original piece of art.

In some instances, the printing press is not faithful in its reproduction of the copy carried by the printing plates because of inherent limitations in the printing process. In other instances, the buyer of the printed copy may desired changes in tonal values so that the printed matter as represented by the output of the press is more satisfying to his customers. For these reasons and others, a method of previewing the results before actually printing the subject matter has been devised whereby the changes and adjustments may be made to the separation transparencies prior to the manufacture of the printing plates.

One method of previewing the color separation of an original colored piece of art work is disclosed in U.S. Patent No. 3,136,637. This patent discloses the use of a multiple layered negative-acting proofing system. In this system each of the colored sheets which have been exposed with the appropriate separation negative are developed and then superimposed one on top of the other in exact register. These transparent sheets containing the colored images in exact detail can then be examined individually or in total to discover any deficiencies as the individual or combined sheets are compared to the original piece of graphic art prior to the manufacture of the printing plates.

In U.S. Patent No. 3,671,236, the same objective is attained by superimposing on a single substrate the several colored layers so that the composite structure more closely resembles the final printed specimen. This is a negative-acting system, wherein a lithographic negative transfers the information photomechanically to the colored proofing sheets.

Still another proofing system is disclosed in U.S. Patent No. 2,993,788, wherein a lithographic negative is used to expose a positive-acting diazo oxide sensitized substrate. By first exposing and developing the sensitized substrate and then applying a dye of predetermined color (using the non-exposed portions of the diazo oxide as a photomask), a single sheet, negative-acting proofing composition is obtained.

In the performance of the prior art methods of generating color proofs from either positive or negative separations, a common problem is generally cited. The background or non-imaged portions of the proof are difficult to preserve from unwanted staining or discoloration (i.e., toning), which degrades the overall value of the composite proof.

U.S. Patent No. 4,260,673 overcomes the problem of unwanted staining by placing a barrier layer between the color containing layer and other layers which are part of the final proof image. The barrier is particularly effective when placed between the colorant containing layer and the thermal adhesive layer. The addition of another layer increases the cost of manufacturing the sheet and introduces additional variables (such as additional chemicals and transmissivity) into the performance of the sheet.

DE—A—1,912,864 discloses a positive-acting laminable color proofing sheet comprising a photosensitive first layer of a base-soluble organic polymeric resin binder having a positive-acting diazo moiety and a colorant.

### Summary of the invention

The invention provides a colour proofing sheet characterised by a thermal adhesive second layer composed of thermally softenable polymeric material, by said diazo oxide moiety being present in a proportion of at least 15% by weight relative to the binder, by said first layer having an at least substantially polar solvent system in which less than 20% by volume of all solvents are non-polar solvents, and by said second layer having an at least substantially non-polar solvent system in which less than 20% by volume of all solvents are polar solvents. The polymer and solvent systems of these two respective layers are thereby selected so that the colorant or active components of the photosensitive layer are not highly soluble in the polymer and solvent material of the thermal adhesive layer and therefore will not migrate into the thermal adhesive layer.

### Description of the invention

In preferred embodiments, additional layers such as a strippable carrier layer with or without a release coating on one face thereof which is in contact with the photosensitive layer may be provided. A strippable cover layer may also be advantageously used over the thermal adhesive layer. A release layer may also be bonded to the photosensitive color layer which remains adhered to the colour when the sheet is stripped from a base film or carrier layer.

The photosensitive layer suitably comprises a base soluble organic polymeric resin binder having an O-quinone diazide or other positive-acting diazo oxide mixed with, dissolved in, or pendant to the binder. The layer also contains colorant such as a pigment or dye. The diazo oxide must be soluble or otherwise present in amounts of at least 15% by weight in the organic polymeric resin binder. Preferred polymers for this layer are phenolic resins including both resols and novalaks. Base soluble acrylic resins are also useful. The solvent system used during the coating of the photosensitive layer (and the other layers) can have a dramatic effect in the practice of the present invention. Polar solvents, or at least substantially polar solvent mixtures should be used in the coating of this layer. Examples of useful polar solvents include ketones (methyl ethyl ketone, methyl isobutyl ketone, etc.), alcohols or ethers (glycol monomethyl ether, glycol monoethyl ether, ethoxy ethyl acetate), halogenated hydrocarbons (trichloroethane, etc.), esters (ethyl or butyl acetate), and mixtures of those polar solvents, together or with small amounts (less than 20% by volume, preferably less than 10% by volume) of non-polar solvents such as intermediate length hydrocarbons (pentane, hexane, heptane, octane, etc.). These mixtures of small amounts of non-polar solvents and polar solvents constitute the substantially polar solvent mixtures referred to above.

The base-soluble organic polymeric binder (i.e. soluble or readily dispersible in aqueous alkaline solution of pH 13) for the photosensitive layer, as indicated above, is preferably a phenolic resin. Other polymeric materials (such as butvar resin to disperse and hold the colorant) may be dissolved or mixed with that primary resin binder constituent. Epoxy resin may also be mixed or dissolved with the binder to adjust physical properties. Furthermore, crosslinked epoxy or polyurethane resin may be added as may polyisocyanates (or other epoxy resin crosslinking agents) and monoisocyanates to react with the phenolic resin or other polymer constituents.

The thermal adhesive layer suitably comprises an organic polymeric, thermoplastic binder which is not developed (dissolved or softened so as to be readily removed by hand-rubbing with a developer pad) in an aqueous, alkaline solution of pH 13. Any thermoplastic resin softenable at a temperature of less than 200°C, preferably at less than 175°C and most preferably at a temperature less than 160°C (with a preferred range between 100°C and 160°C) is useful as the binder component of this layer if it is not soluble in an aqueous alkaline developer. Preferred polymers are not tacky at 20°C and include, for example, polyenes (styrene, butadiene, acrylonitrile polymers, copolymers and terpolymers), acrylics (e.g., methylmethacrylate, n-butyl acrylate, copolymers thereof, etc.), etc. These polymers are coated out in a solvent which is not completely miscible (and preferably immiscible) in the coating of the photosensitive layer and which is preferably a non-polar solvent or at least substantially non-polar solvent. Solvents such as nonpolar aromatic hydrocarbons (toluene, benzene and the like), and aliphatic hydrocarbons (e.g., intermediate length hydrocarbons such as pentane, hexane, heptane, octane, etc.) are particularly preferred. To the extent that any non-polar solvents are used in coating the photosensitive layer with substantially polar solvent mixtures, the non-polar solvents used in the coating of the thermal adhesive layer may be different from the non-polar solvent in the photosensitive layer. Substantially non-polar solvents, as the term is used in the present invention allows for less than 20% by volume of a compatible polar solvent and preferably less than 10%.

In the most preferred practice of the present invention, polar solvents are used in the coating of the photosensitive layer, and non-polar solvents are used in the coating of the thermal adhesive layer. The presence of less than 5% of the total solvent of the opposite type of solvent in the compositions used to coat each layer is usually quite sufficient to prevent migration of colorant or diazo oxide between layers. The diazo oxide is itself colored (usually yellow) and should remain in constant concentration in the photosensitive layer, so that it also should be prevented from migrating into the thermal adhesive layer.

Any dye or pigment may be used in the photosensitive layer as the colorant. Generally such layers comprise either cyan, magenta, yellow or black colorants. Both organic and inorganic colorants may be used. It is preferred that such colorants not be sensitive (oxidizable, colorizable, or degradable) to aqueous alkaline solutions since they may well be in contact with developer solutions.

The diazo oxide selected should be chosen at least in part on the basis of its relative solubility properties between the photosensitive layer and the thermal adhesive layer. Because the diazo oxides tend to have a yellow color to them, their migration between layers would provide some yellow stain in the background. As diazo oxides are somewhat polar, they would tend to generally have a natural affinity for remaining in the photosensitive layer (with its generally polar solvent) than for migrating into the thermal adhesive layer (with its generally non-polar solvent). Selection of diazo oxides with greater degrees of polarity or particularly great affinity for the particular resin binder used in the photosensitive layer or particularly high insolubility in the polymeric binder used in the thermal adhesive layer should be used to enhance this resistance to migration between layers. Diazo oxides with sulfonyl linking groups to aromatic groups (such as 2,4 - (dioxy - 5 - sulfonyl - [naphthoquinone - 2 - diazido]) - benzophenone) are particularly useful in this regard. The diazo oxide is present in an amount from 6—50 percent by dry weight of the photosensitive layer, preferably as 10—33 percent by dry weight of the layer.

The prepared diazo oxides according to the present invention comprise monofunctional diazo oxides having a molecular weight greater than or equal to 400 and polyfunctional (at least difunctional) diazo oxides having molecular weights greater than or equal to 350. It is more preferred that the diazo oxide groups contain polar groups.

At least one strongly polar group (as strong or stronger than carboxyl) such as sulfonamide, amide,

3

**0 115 899**

urea, and carboxyl, or at least two moderately strong polar groups (as strong or stronger than ethers) such as esters, ketones, hydroxyls, amines, thioethers and ethers are preferred.

Even where the diazo oxide is bound into the polymer chain of an ingredient of the color layer, incompatible solvents are used to prevent interpenetration of other layers by the diazo oxide.

Each of the four colors may be added into separate layers of this general construction.

These and other aspects of the present invention will be shown in the following examples.

Example 1

The example described below outlines the procedure for production and imaging of a magenta image. A qualitatively similar procedure may be followed for each of the other three colors.

Onto a 2-mil polyethylene terephthalate carrier film was coated a release layer having a dry coating weight of 70—80 mg/ft$^2$ (753 to 861 mg/m$^2$). The following solution was extrusion-bar coated as the release layer on the carrier film, then oven dried at 190°F—200°F (88°C—93°C).

| | |
|---|---|
| Deionized water | 72.9 lbs (33.1 kg) |
| Gelvatol® 20/30 polyvinyl alcohol | 2758 g |
| Gelvatol® 20/90 polyvinyl alcohol | 919 g |
| Triton® X-100 surfactant | 40 g |

Once this layer was dried, it was overcoated with the photosensitive color solution. This color solution was prepared in two stages: first, a millbase was made consisting of the following materials:

| | |
|---|---|
| Modified Resinox [a reaction product of Resinox RS 7280 (Monsanto) and 8% by weight of DDI-1410 diisocyanate (Henkel)] as a 29.2% solids solution in MEK (methyl ethyl ketone) | 1360 g |
| Butvar B-76 dispersant (Monsanto) polyvinyl butyral resin | 43 g |
| Watchung Red Pigment 698-D | 170 g |
| Cabot Regal Black Pigment 300R | 2 g |
| After complete milling, more modified Resinox was added in the amount of | 1360 g |

Using this millbase, the actual coating solution was made up within 24 hours of coating:

| | |
|---|---|
| Millbase (adjusted to 31.15% solids) | 1335 g |
| Benzophenone bis diazo oxide | 84 g |
| Additional MEK | 1330 g |

This solution was double-roll coated onto a silicone treated release layer to a green-filter color density of 1.25, giving a dry thickness of approximately 100 mg/ft$^2$ after oven-drying at 190°F—205°F (88°C to 96°C). Finally, the adhesive solution was extrusion-bar coated directly on top of the color layer, and dried at 150°F—200°F (66°C to 93°C) to a final thickness of about 500 mg/ft$^2$ (5382 mg/m$^2$). This solution was made up of 85 g of Pliolite S-5-A styrene-butadiene copolymer (Goodyear) and 920 g of toluene.

A sample of this positive-acting color proofing sheet was heat-pressure laminated at 275°F (135°C) roll setting to a white paper base (made by Schoeller Technical Paper Sales, Inc.). The green-filter densitometer reading for this coating indicated a magenta density of about 1.45. This laminate was exposed through a positive photomask to a high-density UV light source for 6—7 seconds (30 units), and then given the standard aqueous, alkaline development at pH 13. This afforded an image with excellent resolution and virtually no (densitometer readings less than 0.01) background color.

Example 2

A solution was prepared in two stages. First, a cyan millbase was made consisting of the following material:

| | |
|---|---|
| Modified Resinox (as in Example 1) | 24 lbs (10.9 kg) |
| Butvar B-76 (polyvinyl butyral) | 430 g |
| Monastral Blue BT-297-D pigment | 1160 g |
| Monastral Blue BT-284-D pigment | 550 g |
| After complete milling, more modified Resinox was added | 24 lbs (10.9 kg) |

After this solution had been diluted to 31% solids by addition of methyl ethyl ketone, a coating solution was made up by mixing the following:

4

| | |
|---|---|
| Millbase, 31% solids | 10 g |
| Diazo-Resinox, a reaction product of Resinox (42 g) and naphthoquinone-2-diazido-5-sulfonyl chloride (36 g) | 0.95 g |
| Methyl ethyl ketone | 13.5 g |

This coating solution was applied in the same manner on the release layer of Example 1. After coating this solution within 24 hours of preparation and oven-drying at 200°F (93°C), the adhesive layer was prepared and applied as in Example 1. After heat-pressure lamination to white paper base, a yellow-filter densitometer reading indicated a cyan reflectance density of 1.48. After a short exposure to UV light through a positive photomask and aqueous alkaline (pH 13) development, an image with good resolution and no background color was obtained.

Example 3

Example 2 was repeated up to the second stage of color-coat solution preparation. The final color coating solution was prepared by mixing the following:

| | |
|---|---|
| Cyan Millbase (Ex. 2), 31% solids | 10 g |
| Bis-diazo oxide amide, a reaction product 1 mol of 1,3-bis-aminomethylcyclo-hexane and two moles of naphthoquinone-2-diazido-5-sulfonyl chloride | 0.60 g |
| Additional methyl ethyl ketone | 11 g |

This solution was coated onto the release layer described in Example 1 and oven-dried at 200°F (93°C). On top of this was coated the adhesive layer described in the earlier examples. After heat-pressure lamination to white paper base, a yellow-fitler densitometer reading of 1.3 obtained. The laminate was exposed to UV light through a positive photomask for 3 seconds and subjected to aqueous alkaline development, affording an excelelnt cyan image with no background coloration.

Example 4

On top of the release and color layers described in Example 1 was coated the following adhesive solution:

| | |
|---|---|
| Pliolite S-5-A | 10 g |
| Methyl ethyl ketone | 5 g |
| Toluene | 95 g |

This coating was oven-dried at 200°F (93°C) for 2 minutes, then heat-pressure laminated to white paper base. After exposure and processing as in Example 1, a good magenta image with little or no (densitometer reading less than 0.02) background coloration was obtained.

**Claims**

1. A positive-acting laminable color proofing sheet comprising a photosensitive first layer of a base-soluble organic polymeric resin binder having a positive-acting diazo oxide moiety and a colorant, said color proofing sheet being characterised by a thermal adhesive second layer composed of thermally softenable polymeric material, by said diazo oxide moiety being present in a proportion of at least 15% by weight relative to the binder, by said first layer having an at least substantially polar solvent system in which less than 20% by volume of all solvents are non-polar solvents, and by said second layer having an at least substantially non-polar solvent system in which less than 20% by volume of all solvents are polar solvents.

2. A sheet as claimed in claim 1 wherein the solvent system of said photosensitive first layer has less than 10% by volume of a non-polar solvent and said diazo oxide is selected from the group consisting of a monofunctional diazo oxide having a molecular weight equal to or greater than 400 and a polyfunctional diazo oxide having a molecular weight equal or greater than 350.

3. A sheet as claimed in claim 1 or claim 2 wherein the solvent system of said thermal adhesive second layer has less than 10% by volume of a polar solvent.

4. A sheet as claimed in claim 3 wherein the solvent system of said thermal adhesive second layer has less than 5% by volume of polar solvent.

5. A sheet as claimed in any preceding claim wherein the solvent system of said photosensitive first layer has less than 5% by volume of non-polar solvent.

6. A sheet as claimed in any preceding claim wherein a strippable carrier layer is in contact with said photosensitive first layer.

5

# 0 115 899

7. A sheet as claimed in any preceding claim wherein the organic polymeric binder of said photosensitive first layer comprises a phenolic resin.

8. A sheet as claimed in any preceding claim wherein the solvent system for said photosensitive first layer comprises a polar solvent selected from the group consisting of ketone, a halogenated hydrocarbon and an ester.

9. A sheet as claimed in any preceding claim wherein the solvent system for said thermal adhesive second layer comprises a non-polar solvent selected from the group consisting of aromatic hydrocarbons and aliphatic hydrocarbons.

10. A sheet as claimed in claim 9 wherein the thermally softenable polymeric adhesive comprises an organic polymer selected from the group consisting of polyenes and acrylics.

## Patentansprüche

1. Positiv wirkendes, kaschierbares Farbprüfblatt mit einer lichtempfindlichen ersten Schicht aus einem basenlöslichen organischen polymeren Harzbindemittel, das einen positiv wirkenden Diazooxidanteil und einen färbenden Stoff enthält, dadurch gekennzeichnet, daß eine warmklebende zweite Schicht vorhanden ist, die aus einem thermoplastischen polymeren Material besteht, daß der genannte Diazooxidanteil in einer Menge von mindestens 15 Gew.% des Bindemittels vorhanden ist, daß die erste Schicht ein mindestens im wesentlichen polares Lösungsmittelsystem enthält, die zu weniger als 20 Vol.% aller Lösungsmittel aus nichtpolarem Lösungsmittel besteht, und daß die zweite Schicht ein mindestens im wesentlichen nichtpolares Lösungsmittelsystem enthält, das zu weniger als 20 Vol.% aller Lösungsmittel aus polarem Lösungsmittel besteht.

2. Blatt nach Anspruch 1, dadurch gekennzeichnet, daß das Lösungsmittelsystem der lichtempfindlichen ersten Schicht weniger als 10 Vol.% nichtpolares Lösungsmittel enthält und daß das Diazooxid aus der Gruppe ausgewählt ist, die aus den monofunktionellen Diazooxiden mit einem Molekulargewicht von mindestens 400 und dem polyfunktionellen Diazooxiden mit einem Molekulargewicht von mindestens 350 besteht.

3. Blatt nach Anspruch 1 oder 2, dadurch gekennzeichnet, daß das Lösungsmittelsystem aus der warmklebenden zweiten Schicht weniger als 10 Vol.% polares Lösungsmittel enthält.

4. Blatt nach Anspruch 3, dadurch gekennzeichnet, daß das Lösungsmittelsystem der warmklebenden zweiten Schicht weniger als 5 Vol.% polares Lösungsmittel enthält.

5. Blatt nach einem der vorhergehenden Ansprüche, dadurch gekennzeichnet, daß das Lösungsmittelsystem der lichtempfindlichen ersten Schicht weniger als 5 Vol.% nichtpolares Lösungsmittel enthält.

6. Blatt nach einem der vorhergehenden Ansprüche, dadurch gekennzeichnet, daß mit der lichtempfindlichen ersten Schicht eine abziehbare Trägerschicht in Berührung steht.

7. Blatt nach einem der vorhergehenden Ansprüche, dadurch gekennzeichnet, daß das organische polymere Bindemittel der lichtempfindlichen ersten Schicht mindestens teilweise aus einem Phenolharz besteht.

8. Blatt nach einem der vorhergehenden Ansprüche, dadurch gekennzeichnet, daß die lichtempfindliche erste Schicht mindestens teilweise aus einem polaren Lösungsmittel besteht, das aus der Gruppe ausgewählt ist, die aus den Ketonen, halogenierten Kohlenwasserstoffen und Estern besteht.

9. Blatt nach einem der vorhergehenden Ansprüche, dadurch gekennzeichnet, daß das Lösungsmittelsystem für die warmklebende zweite Schicht mindestens teilweise aus einem nichtpolaren Lösungsmittel besteht, das aus den aromatischen und den aliphatischen Kohlenwasserstoffen ausgewählt ist.

10. Blatt nach Anspruch 9, dadurch gekennzeichnet, daß der thermoplastische polymere Klebstoff mindestens teilweise aus einem organischen Polymer besteht, das aus der Gruppe ausgewählt ist, die aus den Polyenen und den Acrylsäurederivaten besteht.

## Revendications

1. Feuille d'épreuve colorée laminable, de caractère positif, comprenant une première couche photosensible d'un liant de résine polymère organique, soluble dans les bases, comportant un fragment de diazo-oxyde de caractère positif et une matière colorante, cette feuille d'épreuve en couleur étant caractérisée en ce qu'elle comprend une seconde couche d'adhérence thermique composée d'une matière polymère ramollissable à la chaleur, en ce que le fragment de diazo-oxyde se trouve dans une proportion d'au moins 15% en poids par rapport au liant, en ce que la première couche susdite comporte au moins un système solvant essentiellement polaire dans lequel moins de 20% en volume de tous les solvants sont des solvants non polaires, et en ce que la seconde couche susdite comporte au moins un système solvant essentiellement non polaire, dans lequel moins de 20% en volume de tous les solvants sont des solvants polaires.

2. Feuille suivant la revendication 1, caractérisée en ce que le système solvant de la première couche photosensible susdite comporte moins de 10% en volume d'un solvant non polaire, et en ce que le diazo-oxyde est choisi dans le groupe comprenant un diazo-oxyde monofonctionnel d'un poids moléculaire égal ou supérieur à 400, et un diazo-oxyde polyfonctionnel d'un poids moléculaire égal ou supérieur à 350.

3. Feuille suivant la revendication 1 ou la revendication 2, caractérisée en ce que le système solvant de la seconde couche adhésive thermique comporte moins de 10% en poids de solvant polaire.

4. Feuille suivant la revendication 3, caractérisée en ce que le système solvant de la seconde couche adhésive thermique comporte moins de 5% en volume de solvant polaire.

5. Feuille suivant l'une quelconque des revendications précédentes, caractérisée en ce que le système solvant de la première couche photosensible susdite comporte moins de 5% en volume de solvant non polaire.

6. Feuille suivant l'une quelconque des revendications précédentes, caractérisée en ce qu'une couche de support détachable est en contact avec la première couche photosensible susdite.

7. Feuille suivant l'une quelconque des revendications précédentes, caractérisée en ce que le liant polymère organique de la première couche photosensible susdite consiste en une résine phénolique.

8. Feuille suivant l'une quelconque des revendications précédentes, caractérisée en ce que le système solvant pour la première couche photosensible susdite comprend un solvant polaire choisi dans le groupe comprenant une cétone, un hydrocarbure halogéné et un ester.

9. Feuille suivant l'une quelconque des revendications précédentes, caractérisée en ce que le système solvant pour la seconde couche d'adhérence thermique comprend un solvant non polaire choisi dans le groupe comprenant des hydrocarbures aromatiques et des hydrocarbures aliphatiques.

10. Feuille suivant la revendication 9, caractérisée en ce que l'adhésif polymère ramollissable par voie thermique consiste en un polymère organique choisi dans le groupe comprenant les polyènes et les acryliques.